Europäisches Patentamt

European Patent Office

Office européen des brevets

(19)

(11) Veröffentlichungsnummer: **0 158 318**
**B1**

(12) **EUROPÄISCHE PATENTSCHRIFT**

(45) Veröffentlichungstag der Patentschrift: **14.03.90**

(21) Anmeldenummer: **85104275.4**

(22) Anmeldetag: **09.04.85**

(51) Int. Cl.⁵: **C 03 C 17/245,** C 23 C 14/08, G 02 B 1/10

(54) **Verfahren zum Herstellen der Zinndioxid-Interferenzschicht(en) insbesondere von wärmereflektierend beschichteten Glasscheiben durch reaktive MAGNETRON-Zerstäubung sowie mit einer danach hergestellten Zinndioxidschicht versehene wärmereflektierende Glasscheibe.**

(30) Priorität: **11.04.84 DE 3413587**

(43) Veröffentlichungstag der Anmeldung:
**16.10.85 Patentblatt 85/42**

(45) Bekanntmachung des Hinweises auf die Patenterteilung:
**14.03.90 Patentblatt 90/11**

(84) Benannte Vertragsstaaten:
**AT BE CH DE FR GB IT LI LU NL SE**

(56) Entgegenhaltungen:
**EP-A-0 104 870**
**DE-A-2 102 243**
**US-A-3 139 396**

(73) Patentinhaber: **FLACHGLAS AKTIENGESELLSCHAFT**
**Otto-Seeling-Promenade 10-14**
**D-8510 Fürth (DE)**

(72) Erfinder: **Groth, Rolf, Dr.**
**Holzstrasse 218**
**D-4630 Bochum 6 (DE)**
Erfinder: **Müller, Dieter, Dipl.-Phys.**
**Birlenbacher Strasse 189**
**D-5900 Siegen 21 (DE)**

(74) Vertreter: **Goddar, Heinz J., Dr. et al**
**FORRESTER & BOEHMERT Widenmayerstrasse 4/I**
**D-8000 München 22 (DE)**

EP 0 158 318 B1

**Beschreibung**

Die Erfindung betrifft ein Verfahren zum Herstellung von insbesondere als wärmereflektierende Beschichtung für Glasscheiben oder dgl. dienenden Zinndioxid-Interferenzschicht(en) unter Verwendung eines Zinntargets nach dem einleitenden Teil des Hauptanspruches.

Bei der Herstellung von Interferenzfiltern dieser Art hat sich als Vakuum-Beschichtungsverfahren insbesondere die MAGNETRON-Zerstäubung (US—A—4 166 018; EP—A—0 104 870) bewährt, da sie sich durch hohe Beschichtungsraten auszeichnet. Dieses Verfahren ermöglicht in besonders wirtschaftlicher Weise die Herstellung der bei solchen Filtern verwendeten Interferenzschichten. Als Material dafür ist insbesondere Zinndioxid geeignet. Zinndioxidschichten lassen sich nämlich mit hohen Zerstäubungsraten nach dem Verfahren der reaktiven MAGNETRON-Zerstäubung herstellen. Bei diesem Verfahren erfolgt die Zerstäubung von Zinntargets in einer Gasatmosphäre, welche Sauerstoff enthält, wobei sich durch den reaktiven Prozeß auf dem Substrat eine Zinndioxidschicht bildet.

Bei der Herstellung der Zinndioxid-Interferenzschicht(en) von wenigstens eine Gold-, Silberoder Kupferschicht aufweisenden Interferenzfiltern, wie sie insbesondere als wärmereflektierende Beschichtung von Glasscheiben verwendet werden, durch reaktive MAGNETRON-Zerstäubung von Zinntargets treten bei längerer Betriebszeit Störungen im Beschichtungsprozeß auf. Diese Störungen ergeben sich—nach vorheriger Reinigung der Anodenbleche—nach einer Betriebszeit der Kathoden von etwa 50 Stunden, wenn der Beschichtungsprozeß mit der aus wirtschaftlichen Gründen erforderlichen möglichst hohen Aufstäubrate der Zinndioxidschicht von etwa 40 Å/sec. durchgeführt wird. Bei entsprechend niedrigen Aufstäubraten dauert es entsprechend länger, bis die Störungen im Beschichtungsprozeß einsetzen.

Dabei kommt es in Verbindung mit einem elektrischen Überschlag von der Targetoberfläche zu den seitlich angeordneten Anoden zu lokalen Schichtbeschädigungen in Form von Flecken von mehreren Zentimetern Ausdehnung auf dem beschichteten Substrat. Diese Flecken haben z.B. ein bläuliches, visuell stark störendes Aussehen, wenn bei einem Interferenzfilter, bei welchem die wärmereflektierende Silberschicht beidseitig in Zinndioxid-Schichten eingebettet ist, auf die Silberschicht die äußere Interferenzschicht aus Zinndioxid unter Auftreten dieser Störungen aufgebracht wird.

Auslösendes Element für die Schichtstörungen ist in allen Fällen ein elektrischer Überschlag von der Targetoberfläche zu den seitlich angeordneten Anoden. Solche Überschläge in Form einer lokalen Lichtbogenentladung können bei Dauerbetrieb der Kathoden in gewissen Zeitabständen immer auftreten. Dafür gibt es verschiedene Ursachen, wie z.B. eine Porosität der Targetoberfläche oder Beschichtungsmaterial, welches sich von den Anodenoberflächen oder anderen Abschirmblechen löst und auf die Targetoberfläche fällt.

Ein solcher Überschlag beeinträchtigt an und für sich die Schichtqualität noch nicht in störendem Maße. Durch die elektronische Schutzschaltung der Sputterversorgung wird nämlich die Lichtbogenentladung durch Abschalten der an der Kathode liegenden Spannung sofort gelöscht. Nach einer Abschaltzeit von einigen 10 Millisekunden wird dann das Entladungsplasma wieder gezündet. Auch die durch diese Abschaltzeit ausgelöste Unterbrechung des Beschichtungsprozesses ist dabei noch so kurzzeitig, daß dadurch keine störenden Schichtschwankungen hervorgerufen werden. Störende Schichtveränderungen in Verbindung mit einem elektrischen Überschlag ergeben sich—wie bereits ausgeführt — erst nach längerer Betriebszeit der Kathode. Die Ursachen dafür sind nicht bekannt. Wir vermuten, daß ein Zusammenhang besteht mit den sich im Laufe der Zeit bei Durchführung des reaktiven Beschichtungsprozesses auf den seitlichen Anodenoberflächen bildenden Ablagerungsschichten. Bei diesen Ablagerungen handelt es sich um Zinnmaterial, das durch die Wechselwirkung mit dem reaktiven Plasma während der Diffusion zu diesen Flächen zumindest teilweise oxidiert wird. Die Zusammensetzung dieser Ablagerungsschichten ist nicht genau bekannt.

Es wird vermutet, daß diese Ablagerungsschichten eine elektrische Isolationswirkung aufweisen, wenn ihre Dicke einen Mindestwert überschreitet. Es zeigen sich nämlich auf ihnen "blitzartige" Entladungsspuren, wenn es nach der genannten Betriebszeit der Kathoden von etwa 50 Stunden zu den störenden Schichtfehlern kommt. Dementsprechend wird man vermuten, daß die mit einem elektrischen Überschlag von der Targetoberfläche zu den Anoden auftretenden lokalen hohen elektrischen Ströme durch die Ablagerungsschichten hindurch nicht mehr ausreichend gut zur darunterliegenden Metallfläche abgeführt werden. Diese Strombehinderung führt dazu, daß die elektronische Schutzschaltung die Kathode beim Auftreten eines Überschlages nicht mehr sofort abschaltet, weil die benötigten Soll-Überstromwerte nicht oder nicht schnell genug erreicht werden. Die Folge davon könnte sein, daß das lokale intensive Plasma bei der sich ergebenden längeren Einwirkungszeit zu Schichtbeschädigungen führt. Hierbei handelt es sich aber nur um eine mögliche Erklärung des Phänomens, dessen Ursachen letztlich nicht bekannt sind, da sich wegen der Komplexität der Vorgänge beim Zünden derartiger Lichtbogenentladungen nur Vermutungen anstellen lassen.

Insgesamt haben die vorstehend beschriebenen Störungen, insbesondere die auf die Ablagerungen auf den Anoden zurückzuführenden, einen negativen Einfluß auf diejenige Betriebszeit, welche ohne störende Schichtveränderungen bei der Herstellung der entsprechenden Interferenzfilter zugelassen werden kann.

Aus der DE—A—2 102 243 ist est bereits bekannt, die elektrisch leitenden Elektroden von Flüssigkristallzellen dadurch herzustellen, daß Glasscheiben unter Verwendung eines einen gewissen Antimongehalt aufweisende Zinntargets mit antimondotierten · Zinnoxidschichten belegt werden, die eine hohe elektrische Leitfähigkeit aufweisen, wobei aber die vorstehend beschriebenen Schwierigkeiten bei der Herstellung wärmereflektierender Zinndioxidschichten als Bestandteile von Interferenzfiltern, insbesondere bei wärmereflektierenden Glasscheiben, nicht angesprochen sind. Auch bei einem aus der US—A—3 139 396 beschriebenen Verfahren dient die Verwendung eines einen Antimongehalt aufweisenden Zinntargets dazu, eine mit Antimon "verunreinigte" Zinndioxidschicht zu erhalten, welche eine hohe elektrische Leitfähigkeit hat, ohne daß es auf die optischen Eigenschaften der so hergestellten Schichten ankäme.

Der Erfindung liegt die Aufgabe zugrunde, ein Verfahren der eingangs genannten Art zu schaffen, welches ohne Qualitätsbeeinträchtigung des herzustellenden Interferenzfilters eine verlängerte Betriebsdauer für den Beschichtungsprozeß ermöglicht.

Erfindungsgemäß wird diese Aufgabe bei einem Verfahren der eingangs genannten Art durch das Merkmal des kennzeichnenden Teiles des Hauptanspruches gelöst.

Besonders bevorzugte Ausführungsformen des Verfahrens nach der Erfindung sind Gegenstand der auf den Hauptanspruch zurückbezogenen Unteransprüche der Verfahrenskategorie. Gegenstand der Erfindung ist ferner eine nach dem erfindungsgemäßen Verfahren mit einer Zinndioxid-Interferenzschicht versehene wärmereflektierende Glasscheibe.

Der Erfindung liegt die überraschende Erkenntnis zugrunde, daß die Betriebsdauer von MAGNETRON-Kathodenzerstäubungsanlagen beim Aufbringen von Zinndioxid-Interferenzschichten unter Behebung der bislang beobachteten Kathodenstörungen bei Langzeitbetrieb dadurch entscheidend verlängert werden kann, daß für die reaktive Zerstäubung Zinntargets verwendet werden, welche geringe Zusätze wenigstens eines Metalls aus den Gruppen $V_a$ und $V_b$ des Periodischen Systems enthalten. Diese Zusätze sind dabei so gering, daß bei den erforderlichen Interferenzschichtdicken von bis etwa 60 nm durch den Zusatz in den $SnO_2$-Schichten noch keine Zusatzabsorption für sichtbares Licht ausgelöst wird, so daß also die für Interferenzfilter der in Rede stehenden Art erwünschte hohe Lichtdurchlässigkeit erhalten bleibt.

Nachfolgend ist ein Ausführungsbeispiel der Erfindung im einzelnen beschrieben.

Beispiel

Zur Herstellung eines als wärmereflektierende Beschichtung einer Fensterscheibe dienenden Interferenzfilters wurde eine Silikatglasscheibe in einer MAGNETRON-Kathodenzerstäubungsanlage mit einem Interferenzfilter des Aufbaus $SnO_2$-Ag-$SnO_2$ beschichtet. Es wurde ein Zinntarget verwendet, welches mit 1 Gew.-%, bezogen auf die Zinnmasse, Antimon dotiert war. Auch nach einer Betriebszeit von 100 Stunden wurden beim Aufsputtern der $SnO_2$-Schichten durch die reaktive MAGNETRON-Zerstäubung keine erkennbaren Schichtstörungen verursacht, vielmehr waren die hergestellten Interferenzfilter über die gesamte vorgenannte Betriebsdauer, die mit einer bisher möglichen Betriebsdauer von ca. 50 Stunden vergleichbar ist, über die gesamte Scheibenoberfläche optisch einwandfrei.

Bei Verwendung der erfindungsgemäßen Zinntargets mit Zusätzen zeigte sich überraschenderweise ferner, daß auch die Zahl der elektrischen Überschläge und der damit durch sie von der elektronischen Schutzschaltung ausgelösten Kathodenabschaltungen geringer als bei einem Target ohne Zusatz ist. Das ist ein weiterer Vorteil der Verwendung eines Targets mit den genannten Zusätzen. Wie bereits gesagt, ist zwar eine gelegentliche Kathodenabschaltung für die Qualität der Beschichtung noch nicht nennenswert nachteilig, da durch sie der Beschichtungsprozeß nur kurzzeitig unterbrochen wird. Das gilt jedoch nicht mehr, wenn sich solche Abschaltungen zeitlich häufen, und die statistische Wahrscheinlichkeit solcher Häufungen wird naturgemäß geringer, wenn die Zahl der Abschaltungen insgesamt kleiner ist.

**Patentansprüche**

1. Verfahren zum Herstellen der Zinndioxid-Interferenzschicht(en) eines wenigstens eine wärmereflektierende Gold-, Silber- oder Kupferschicht sowie wenigstens eine Zinndioxid-Interferenzschicht aufweisenden Interferenzfilters, insbesondere als wärmereflektierende Beschichtung einer Glasscheibe oder dgl., durch reaktive MAGNETRON-Zerstäubung unter Verwendung eines Zinntargets, dadurch gekennzeichnet, daß für die reaktive MAGNETRON-Zerstäubung ein Zinntarget verwendet wird, welches einen Zusatz wenigstens eines Metalls aus den Gruppen $V_a$ oder $V_b$ des Periodischen Systems enthält.

2. Verfahren nach Anspruch 1, dadurch gekennzeichnet, daß der Zinntargetzusatz zwischen 0,3 und 4 Gew.-%, bezogen auf die Zinnmasse des Zinntarget, beträgt.

3. Verfahren nach Anspruch 2, dadurch gekennzeichnet, daß der Zinntargetzusatz ca. 1 Gew.-%, bezogen auf die Zinnmasse des Zinntargets, beträgt.

4. Verfahren nach einem der vorangehenden Ansprüche, dadurch gekennzeichnet, daß als Zinntargetzusatz Antimon verwendet wird.

5. Wärmereflektierende Glasscheibe mit einer wenigstens eine wärmereflektierende Gold-, Silber- oder Kupferschicht sowie wenigstens eine Zinndioxid-Interferenzschicht aufweisenden wärmereflektierenden Beschichtung, dadurch gekennzeichnet, daß die Zinndioxidschicht(en) nach dem Verfahren nach einem der vorangehenden Ansprüche hergestellt ist bzw. sind.

## Revendications

1. Procédé pour fabriquer la ou les couches d'interférence en dioxyde d'étain d'un filtre d'interférence comportant au moins une couche d'or, d'argent ou de cuivre ainsi qu'au moins une couche d'interférence en dioxyde d'étain, servant notamment de revêtement réfléchissant la chaleur d'une plaque de verre ou similaire, par pulvérisation réactive au MAGNETRON en utilisant une cible en étain, caractérisé en ce que pour la pulvérisation réactive au MAGNETRON on utilise une cible en étain qui contient une addition d'au moins un métal des groupes $V_a$ ou $V_b$ de la classification périodique.

2. Procédé selon la revendication 1, caractérisé en ce que l'addition de la cible en étain est comprise entre 0,3 et 4% en poids, en se basant sur la masse de l'étain de la cible en étain.

3. Procédé selon la revendication 2, caractérisé en ce que l'addition de la cible en étain est égale à 1% en poids environ en se basant sur la masse de l'étain de la cible en étain.

4. Procédé selon l'une des revendications précédentes, caractérisé en ce qu'on utilise de l'antimoine en tant qu'addition de la cible en étain.

5. Plaque de verre réfléchissant la chaleur comportant un revêtement réfléchissant la chaleur qui présente au moins une couche réfléchissant la chaleur en or, en argent ou en cuivre ainsi qu'au moins une couche d'interférence en dioxyde d'étain, caractérisée en ce que la ou les couches en dioxyde d'étain sont fabriquées d'après le procédé suivant l'une des revendications précédentes.

## Claims

1. A process for making tin dioxide interference layer(s) for an interference filter comprising at least one heat-reflecting gold, silver or copper layer and at least one tin dioxide interference layer, more particularly as a heat-reflecting coating for a pane of glass or the like, by reactive magnetron sputtering using a tin target, characterised in that the tin target used for the reactive magnetron atomization contains an addition of at least one metal of groups $V_a$ or $V_b$ of the periodic system.

2. A process according to claim 1, characterised in that the tin target addition is between 0.3 and 4% by weight with respect to the tin mass of the tin target.

3. A method according to claim 3, characterised in that the tin target addition is about 1% by weight with respect to the tin mass of the tin target.

4. A process according to any one of the preceding claims, characterised in that antimony is used as the tin target addition.

5. A heat reflecting pane of glass comprising a heat-reflecting coating comprising at least one heat-reflecting gold, silver or copper layer and at least one dioxide interference layer, characterised in that the tin dioxide layer or layers is/are made by the process according to any one of the preceding claims.